# FASCICULE DE BREVET EUROPEEN

(11) **EP 3 038 151 B1**
(45) Date de publication et mention de la délivrance du brevet: **21.06.2017**
(21) Numéro de dépôt: 15201758.8
(22) Date de dépôt: 21.12.2015
(51) Int. Cl.: H01L 23/367, H01L 23/473, H05K 7/20

(54) **PLAQUE FROIDE, FORMANT NOTAMMENT PARTIE STRUCTURALE D'UN ÉQUIPEMENT À COMPOSANTS GÉNÉRATEURS DE CHALEUR**
KÄLTEPLATTE, DIE INSBESONDERE EIN STRUKTURELEMENT EINER AUSRÜSTUNG MIT WÄRMEERZEUGENDEN KOMPONENTEN BILDET
COLD PLATE, IN PARTICULAR FORMING THE STRUCTURAL PORTION OF A DEVICE WITH HEAT-GENERATING COMPONENTS

(30) Priorité: 22.12.2014 FR 1463072
(43) Date de publication de la demande: 29.06.2016
(73) Titulaire: Airbus Operations, 31060 Toulouse (FR)
(72) Inventeur: PONS, Philippe, 31600 MURET (FR); SALLES, Pierre, 31880 La Salvetat St Gilles (FR)
(74) Mandataire: Santarelli

(56) Documents cités:
- EP-A1- 1 175 135
- JP-A- 2001 035 981
- JP-A- 2004 063 654
- JP-A- 2006 202 800
- JP-A- 2008 004 667
- JP-A- 2011 134 979
- JP-A- 2013 175 532
- US-A- 4 315 300
- US-A- 4 322 776
- US-A1- 2006 157 858
- US-A1- 2007 041 160
- US-A1- 2008 029 260

## Description

### DOMAINE TECHNIQUE

La présente invention concerne une plaque froide pour le refroidissement de composants générateurs de chaleur.

De manière générale, l'invention concerne le domaine du refroidissement de composants générateurs de chaleur tels que des systèmes électriques avec une consommation électrique élevée ou des systèmes électroniques présentant une forte densité thermique.

### ETAT DE LA TECHNIQUE

Classiquement, les plaques froides peuvent être utilisées pour le refroidissement de circuits mettant en oeuvre des composants d'électronique de puissance, ou encore pour le refroidissement de points chauds générés au niveau des cartes de circuits imprimés.

En particulier, des plaques froides peuvent être utilisées pour le refroidissement des équipements avioniques présents dans les aéronefs.

Dans ce type d'utilisation, il est nécessaire d'obtenir un bon refroidissement thermique des composants générateurs de chaleur tout en limitant le volume et la masse des systèmes de refroidissement.

On connaît ainsi une plaque froide telle que décrite dans le document US 2011/0232863, qui comporte plusieurs plaques s'étendant parallèlement les unes aux autres, l'une des plaques étant configurée pour supporter un dispositif générateur de chaleur.

La plaque froide comprend un cadre disposé entre deux plaques et définissant une cavité entre les deux plaques.

La cavité loge une structure d'ailettes, un fluide de refroidissement circulant à travers la cavité et la structure d'ailettes pour refroidir le dispositif générateur de chaleur disposé sur la plaque froide.

Le fluide de refroidissement est introduit dans la cavité de la plaque froide et récupéré grâce à des orifices d'entrée et de sortie disposés dans un même coin de la plaque froide.

La plaque froide est fixée elle-même sur un élément de structure, celui-ci étant fixé par exemple à une paroi de cabine ou à une baie avionique.

L'élément de structure et la plaque froide constituent ainsi des moyens pour supporter la charge structurale du dispositif générateur de chaleur.

Le document JP 2013 175532 A (MITSUBISHI ELECTRIC CORP) 5 septembre 2013 décrit une plaque froide.

### RESUME DE L'INVENTION

La présente invention a pour but de proposer une plaque froide améliorée, présentant notamment une bonne efficacité de refroidissement.

A cet effet, la présente invention concerne une plaque froide pour le refroidissement de composants générateurs de chaleur, comprenant deux plaques s'étendant parallèlement l'une à l'autre et une âme disposée entre les deux plaques pour former une structure sandwich, l'âme comprenant un ensemble de canaux de circulation d'au moins un fluide de refroidissement d'un premier bord à un second bord opposé de la structure sandwich.

Selon l'invention, des premier et second éléments de raccord étanche sont disposés respectivement auxdits premier et second bords opposés de la structure sandwich, le premier élément de raccord étanche comportant au moins un connecteur d'entrée d'au moins un fluide de refroidissement et le second élément de raccord étanche comportant au moins un connecteur de sortie d'au moins un fluide de refroidissement, les premier et second éléments de raccord étanche obturant l'ensemble de canaux de circulation hormis au moins un sous-ensemble de l'ensemble de canaux de circulation, ledit au moins un connecteur d'entrée d'au moins un fluide de refroidissement étant en communication avec le sous-ensemble de l'ensemble de canaux de circulation, et ledit au moins un connecteur de sortie dudit au moins un fluide de refroidissement étant en communication avec le sous-ensemble de l'ensemble de canaux de circulation.

La circulation d'au moins un fluide de refroidissement dans un ensemble de canaux de circulation et la disposition d'un connecteur d'entrée et
d'un connecteur de sortie au niveau de deux bords opposés de la structure sandwich permet de générer un flux de fluide de refroidissement particulièrement efficace au travers de l'âme de la plaque froide.

La structure sandwich réalisée à partir d'une âme disposée entre deux plaques confère à la plaque froide ainsi obtenue une bonne résistance mécanique.

La réalisation de canaux de circulation dans l'âme de la structure sandwich de la plaque froide évite la mise en oeuvre de tubes de circulation de fluide de refroidissement, ce qui permet un gain de masse de la plaque froide.

Les éléments de raccord étanche permettent d'obtenir une modularité de la plaque froide, pour une même structure sandwich ; en fonction des éléments de raccord étanche mis en oeuvre, un ou plusieurs sous-ensembles de canaux de circulation peuvent être définis dans la plaque froide pour réaliser des couloirs de circulation de fluide de refroidissement au sein de la plaque froide en fonction des points chauds à refroidir.

Selon différentes caractéristiques et divers modes de réalisation de l'invention, qui peuvent être pris isolément ou en combinaison :
- le premier élément de raccord étanche, respectivement le second élément de raccord étanche, comporte plusieurs connecteurs d'entrée, respectivement plusieurs connecteurs de sortie, de fluides de refroidissement différents ;
- les premier et second éléments de raccord étanche sont insérés et fixés entre les deux plaques se prolongeant au-delà de l'âme ;
- l'ensemble de canaux de circulation comprend des canaux fermés par au moins l'une des deux plaques et débouchant respectivement au premier bord et au second bord opposé de la structure sandwich ;
- les canaux comprennent chacun deux parois respectivement adjacentes à au moins l'une des deux plaques ;
- les deux parois sont inclinées l'une par rapport à l'autre et adjacentes l'une à l'autre pour former un fond de canal ;
- l'âme a une forme ondulée, le sommet des ondulations étant en contact avec au moins l'une desdites deux plaques ;
- la direction de circulation dudit au moins un fluide de refroidissement dans l'ensemble de canaux de circulation correspond à une direction longitudinale de la structure sandwich, l'âme réalisant une fermeture étanche de la plaque froide sur des bords longitudinaux de la plaque froide ;
- l'ensemble de canaux de circulation comprend des canaux parallèles les uns aux autres ;
- les canaux sont disposés en zigzag du premier bord au second bord opposé de la structure sandwich.

A titre d'exemple, le fluide de refroidissement est un liquide, tel que de l'eau, ou un gaz, tel que de l'air.

Selon un second aspect, la présente invention concerne également un système de refroidissement de composants générateurs de chaleur, comprenant une plaque froide telle que décrite précédemment, des composants générateurs de chaleur étant disposés en contact avec au moins l'une des deux plaques.

Selon un troisième aspect, la présente invention concerne finalement l'utilisation d'une plaque froide telle que décrite précédemment comme partie structurale d'un équipement avionique dans un aéronef.

La structure sandwich formant la plaque froide est particulièrement bien adaptée à être utilisée directement comme partie structurale d'un équipement comportant des composants générateurs de chaleur.

La plaque froide joue ainsi une double fonction dans l'équipement, permettant à la fois le support des composants générateurs de chaleur et leur refroidissement.

On gagne ainsi en encombrement et en masse de l'équipement lors de la mise en oeuvre d'un tel système de refroidissement.

### BREVE DESCRIPTION DES DESSINS

D'autres particularités et avantages de l'invention apparaîtront encore dans la description ci-après.

Aux dessins annexés, donnés à titre d'exemples non limitatifs :
- la figure 1 est une vue schématique en perspective éclatée d'une structure sandwich d'une plaque froide selon un premier mode de réalisation de l'invention ;
- la figure 2 est une vue schématique en perspective d'une plaque froide équipée d'un composant générateur de chaleur selon le premier mode de réalisation de l'invention ;
- la figure 3 est une vue de dessus avec des parties arrachées de la plaque froide de la figure 2 ;
- la figure 4 est une vue de dessus schématique éclatée de la plaque froide de la figure 3, illustrant un premier mode de circulation d'un fluide de refroidissement ;
- la figure 5 est une vue analogue à la figure 4 illustrant un second mode de circulation de fluide de refroidissement ;
- les figures 6A et 6B sont des schémas en perspective illustrant des modes de réalisation alternatifs d'une âme mise en oeuvre dans une structure sandwich d'une plaque froide selon différents modes de réalisation de l'invention ; et
- la figure 7 est une vue schématique en perspective illustrant un exemple d'utilisation de plaques froides dans une structure électronique du type cabi net.

### DESCRIPTION DETAILLEE

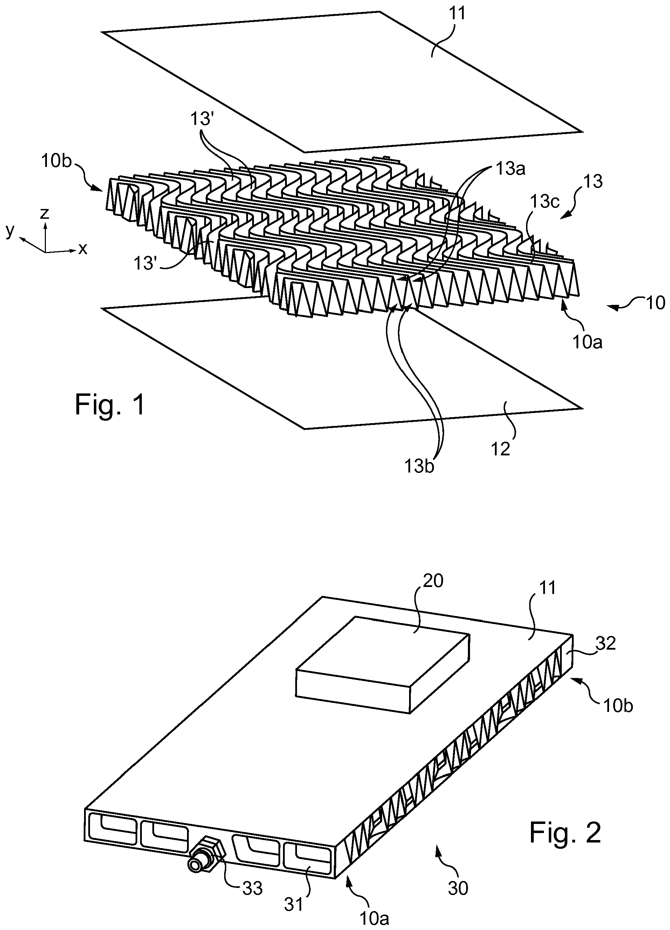

On va décrire à présent en référence aux figures 1 à 3 une plaque froide pour le refroidissement de composants générateurs de chaleur selon un premier mode de réalisation de l'invention.

Dans la suite de la description, le terme "comprenant" n'exclut pas d'autres éléments ou étapes et le terme "un" n'exclut pas le pluriel.

Comme bien illustré à la figure 1, le principe de la plaque froide selon un premier mode de réalisation de l'invention repose sur la formation d'une structure sandwich 10.

Plus particulièrement, deux plaques 11, 12 sont disposées parallèlement l'une à l'autre et une âme 13 est placée en sandwich entre les deux plaques 11, 12 pour former ainsi la structure sandwich 10.

Les plaques 11, 12 constituent ainsi les deux peaux externes de la structure sandwich 10, alors que l'âme 13 constitue le coeur de cette structure sandwich 10.

A titre d'exemple non limitatif, les plaques 11, 12 peuvent être réalisées en métal ou à partir de matériaux composites.

Ainsi, lorsque la plaque froide est destinée à être utilisée dans des équipements avioniques, les matériaux composites répondant aux contraintes aéronautiques peuvent être utilisés.

De même, l'âme 13 peut être réalisée à partir de matériaux métalliques ou composites.

De manière générale, et en fonction de l'utilisation et de l'application recherchée de la plaque froide, les plaques 11, 12 et l'âme 13 peuvent être des composants pris sur étagère (en anglais, COTS acronyme du terme *"Commercial Off-The-Shelf"*) ou alternativement être des composants réalisés sur mesure.

Les plaques 11, 12 et l'âme 13 peuvent être solidarisées les unes aux autres par un procédé de collage, et par exemple par la mise en oeuvre d'un procédé de collage de matériaux composites.

A titre d'exemple non limitatif, un tel procédé de collage peut mettre en oeuvre des étapes de décapage et nettoyage des plaques 11, 12 et de l'âme 13, puis une étape d'encollage suivie d'une étape de cocuisson pour solidariser l'ensemble de ces pièces et obtenir la structure sandwich 10.

Alternativement, la structure sandwich 10 pourrait être réalisée en mettant en oeuvre un procédé de fabrication additive du type ALM (acronyme du terme anglo-saxon *"Additive Layer Manufacturing"*).

L'âme 13 comprend un ensemble de canaux de circulation 13a, 13b permettant la circulation d'un fluide de refroidissement.

Comme bien illustré à la figure 1, dans ce mode de réalisation, l'ensemble de canaux de circulation 13a, 13b permet la circulation d'un fluide de refroidissement d'un premier bord 10a à un second bord opposé 10b de la structure sandwich 10.

En référence à la figure 1, on définit une direction longitudinale Y de la structure sandwich 10 comme correspondant à la direction de circulation du fluide de refroidissement, les premier et second bords opposés 10a, 10b correspondant ainsi à des bords latéraux opposés de la structure sandwich 10, s'étendant selon une direction transversale X de la structure sandwich 10.

Dans la structure sandwich ainsi formée, l'ensemble de canaux de circulation 13a, 13b comprend des canaux 13a, 13b fermés par l'une des deux plaques 11, 12.

Les canaux 13a, 13b débouchent respectivement au niveau du premier bord 10a et du second bord 10b de la structure sandwich 10.

L'âme 13 présente ainsi globalement une forme ondulée, dans laquelle le sommet des ondulations vient en contact avec l'une des deux plaques 11, 12.

Dans ce mode de réalisation, les canaux 13a, 13b sont formés chacun par deux parois 13' inclinées l'une par rapport à l'autre et adjacentes l'une à l'autre pour former un fond de canal 13c.

Ici, les parois inclinées 13' de chaque canal 13a, 13b sont adjacentes à l'une des deux plaques 11, 12.

Par ailleurs, le fond de canal 13c formé par deux parois inclinées 13' vient également en contact avec l'une des deux plaques 11, 12.

Ainsi, dans ce mode de réalisation, l'âme 13 a globalement une forme ondulée, les ondulations venant en contact avec l'une ou l'autre des deux plaques 11, 12.

Le creux de chaque ondulation forme un canal de circulation 13a, 13b du fluide de refroidissement, fermé par l'une des deux plaques 11, 12 s'étendant entre les sommets 13c de deux ondulations voisines.

Ainsi, le fluide de refroidissement qui circule dans les canaux 13a, 13b est directement en contact avec les deux plaques 11, 12 permettant de favoriser un refroidissement direct de composants générateurs de chaleur placés en contact avec l'une et/ou l'autre des deux plaques 11, 12 comme cela sera décrit ultérieurement.

Dans ce mode de réalisation et de manière non limitative, l'âme 13 est constituée plus précisément d'une structure ayant un profil transversal, en forme de zigzag dans le plan perpendiculaire à la direction longitudinale Y de la structure sandwich 10.

Chaque canal 13a, 13b est ainsi défini entre deux parois inclinées 13', définissant des canaux de forme prismatique triangulaire.

Chaque canal 13a, 13b est ainsi défini entre la base de la forme prismatique fermée par une des plaques 11, 12 et le sommet de la forme prismatique venant en contact avec l'autre des deux plaques 11, 12.

Un premier réseau de canaux 13a est ainsi défini par des parois inclinées 13' et une première plaque 11 et un second réseau de canaux 13b est défini par des parois inclinées 13' et une seconde plaque 12.

L'âme 13 permet en outre de conférer une bonne rigidité à la structure sandwich 10 grâce à sa structure nervurée, tout en aménageant des canaux de circulation de fluide de refroidissement entre les deux plaques 11, 12 de la structure sandwich 10.

L'ensemble des canaux de circulation 13a, 13b comprend ainsi des canaux parallèles les uns aux autres.

Dans ce mode de réalisation, les canaux 13, 13b sont identiques les uns aux autres, notamment en terme de largeur dans le plan de structure sandwich 10.

Comme bien illustré à la figure 1, les canaux de circulation 13a, 13b sont disposés en zigzag du premier bord 10a au second bord opposé 10b de la structure sandwich 10.

Ainsi, les canaux de circulation 13a, 13b sont disposés en zigzag dans un plan parallèle aux deux plaques 11, 12, c'est-à-dire dans un plan perpendiculaire à la direction d'empilement Z de la structure sandwich telle qu'illustrée à la figure 1.

L'âme 13 est ainsi constituée de plusieurs portions successives dans la direction longitudinale Y de la structure sandwich 10.

La direction des canaux de circulation 13a, 13b est modifiée d'une portion à l'autre dans le plan de la structure sandwich 10, selon la disposition en zigzag choisie.

La disposition en zigzag des canaux de circulation 13a, 13b du premier bord 10a au second bord opposé 10b de la structure sandwich 10 permet d'augmenter la longueur parcourue par le fluide de refroidissement au travers de la structure sandwich par rapport à la dimension longitudinale de la structure sandwich 10. Cela favorise le refroidissement des composants générateurs de chaleur destinés à être placés en contact avec l'une et/ou l'autre des deux plaques 11, 12 de la structure sandwich 10.

Par ailleurs, la disposition en zigzag des canaux de circulation 13a, 13b dans l'âme 13 de la structure sandwich 10 permet d'améliorer les performances mécaniques de la structure sandwich 10, ce qui peut être particulièrement avantageux lorsque la structure sandwich 10 est utilisée comme partie structurale d'un équipement avionique comme cela sera décrit ultérieurement.

En outre, grâce à la mise en contact direct du fluide de refroidissement avec les plaques 11, 12 de la structure sandwich 10, il n'existe pas d'interfaces thermiques additionnelles entre les composants générateurs de chaleur 20 à refroidir et la plaque froide 30.

Bien entendu, l'exemple d'âme décrit précédemment en référence à la figure 1 n'est pas limitatif, l'âme 13 pouvant présenter différentes structures entre les deux plaques 11, 12 dès lors qu'elle définit un ensemble de canaux de circulation 13a, 13b.

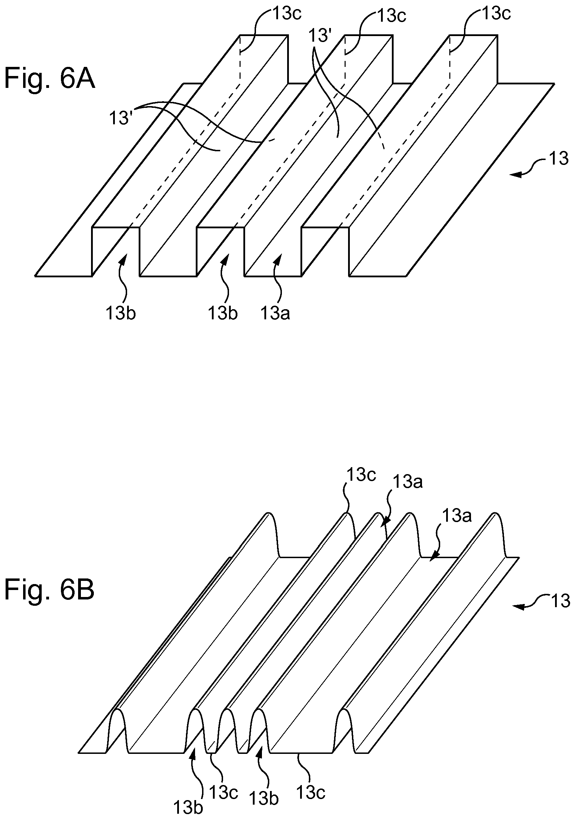

En particulier, on a illustré aux figures 6A et 6B deux exemples alternatifs, non limitatifs, de la structure d'une âme 13.

A la figure 6A, l'âme 13 présente une forme ondulée, les ondulations ayant une section transversale carrée ou rectangulaire.

Le sommet 13c des ondulations est destiné à venir en contact avec au moins l'une des deux plaques 11, 12.

Ainsi, chaque canal 13a, 13b comprend deux parois 13' qui sont adjacentes à l'une des plaques 11, 12.

Selon le mode de réalisation illustré à la figure 6B, l'âme 13 a une forme ondulée, la distance entre chaque ondulation pouvant être variable de telle sorte que la largeur des canaux 13a, 13b peut être variable dans la direction transversale X de la structure sandwich 10.

Ces exemples d'âme 13 ne sont qu'illustratifs et leurs caractéristiques peuvent être combinées les unes aux autres, notamment en ce qui concerne la largeur des canaux 13a, 13b et le contact de l'âme 13 avec l'une et/ou l'autre des plaques 11, 12 de la structure sandwich.

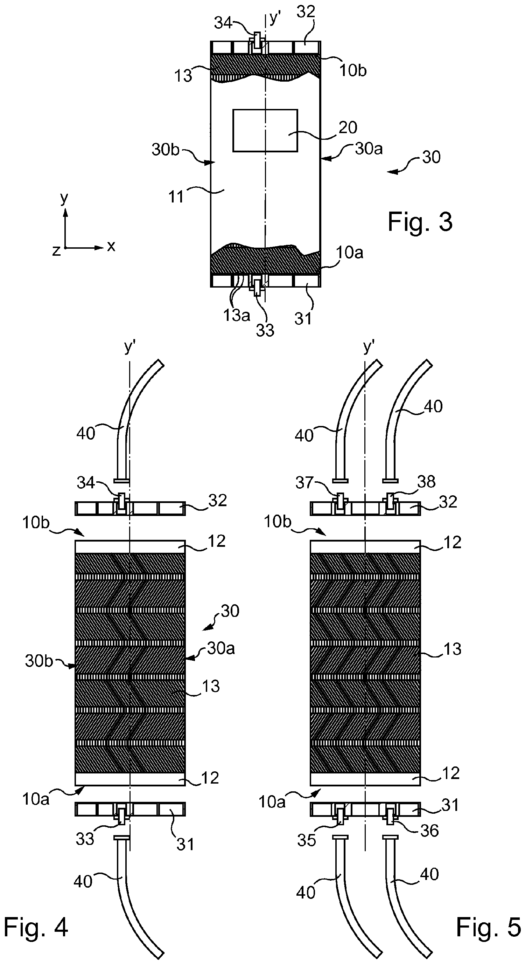

Comme bien illustré aux figures 2 et 3, la plaque froide 30 intégrant la structure sandwich 10 telle que décrite précédemment en référence à la figure 1 comprend des composants générateurs de chaleur (schématisés par le bloc 20), placés ici de manière non limitative sur une des deux plaques 11, 12 de la structure sandwich 10.

Bien entendu, des composants générateurs de chaleur 20 pourraient être placés sur la plaque froide en contact avec l'une et/ou l'autre des deux plaques 11, 12.

Des premier et second éléments de raccord étanche 31, 32 sont disposés respectivement aux premier et second bords opposés 10a, 10b de la structure sandwich 10.

Dans l'exemple décrit en référence aux figures 2 et 3, les premier et second éléments de raccord étanche 31, 32 sont disposés au niveau des bords latéraux de la structure sandwich 10, destinés ainsi à constituer les bords latéraux de la plaque froide 30.

L'ensemble des canaux de circulation 13a, 13b formés dans l'âme 13 de la structure sandwich 10 débouchant au niveau des premier et second bords 10a, 10b de la structure sandwich 10, les premier et second éléments de raccord étanche 31, 32 sont destinés à obturer au moins en partie les canaux de circulation 13a, 13b vis-à-vis du passage d'un fluide de refroidissement.

Les éléments de raccord étanche 31, 32 comportent ainsi de manière générale une paroi permettant d'obturer l'ensemble de canaux de circulation 13a, 13b hormis dans une certaine portion des premier et second bords opposés 10a, 10b de la structure sandwich 10 afin de permettre l'introduction et la récupération d'un fluide de refroidissement.

A cet effet, afin de permettre l'introduction et la sortie d'un fluide de refroidissement dans la plaque froide 30, chaque élément de raccord étanche 31, 32 comporte au moins un connecteur de fluide.

Ici, et de manière non limitative, un premier élément de raccord étanche 31 comporte un connecteur d'entrée 33 destiné à introduire un fluide de refroidissement dans la plaque froide 30 et le second élément de raccord étanche 32 comporte un connecteur de sortie 34 pour permettre l'évacuation du fluide de refroidissement après traversée de la plaque froide.

Les premier et second éléments de raccord étanche 31, 32 peuvent être formés de ferrures de bord, réalisées en métal ou en matériaux composites.

Généralement, les ferrures de bord 31, 32 sont réalisées sur mesure de manière à être adaptées aux dimensions de la structure sandwich 10, et notamment à sa largeur dans la direction transversale X et son épaisseur selon la direction d'empilement Z.

Les ferrures de bord 31, 32 peuvent en outre intégrer des interfaces de report avec la structure destinée à les intégrer, telle que par exemple une structure porteuse d'un aéronef.

Dans le mode de réalisation illustré à la figure 2, les éléments de raccord étanche 31, 32 sont insérés et fixés entre les deux plaques 11, 12, se prolongeant au-delà de l'âme 13.

Les éléments de raccord étanche 31, 32 permettent ainsi pour une même structure sandwich 10 de définir un ou plusieurs sous-ensembles de canaux de circulation 13a, 13b pour former un ou plusieurs couloirs de circulation d'un fluide de refroidissement.

En choisissant de manière adéquate les éléments de raccord étanche 31, 32, il est possible de réaliser des plaques froides, pour une même structure sandwich 10, avec des couloirs de circulation de fluide de refroidissement différents, adaptés à l'utilisation spécifique de chaque plaque froide.

La modularité des plaques froides permet d'adapter celles-ci au refroidissement des composants générateurs de chaleur disposés sur ou au voisinage de l'une et/ou l'autre des deux plaques 11, 12 de la structure sandwich 10.

Les éléments de raccord étanche 31, 32 peuvent être montés par collage entre les deux plaques 11, 12 se prolongeant au-delà de l'âme 13.

Ils peuvent également être fixés par des moyens de montage démontables du type clip, bandes auto-agrippantes, ...

Dans l'exemple de réalisation illustré aux figures 3 et 4, chaque élément de raccord étanche 31, 32 comporte respectivement un connecteur d'entrée 33 et un connecteur de sortie 34 disposés sensiblement au milieu, c'est-à-dire selon une direction correspondant sensiblement à la direction longitudinale centrale Y' de la plaque froide 30.

Ainsi, comme illustré à la figure 4, le connecteur d'entrée 33 d'un fluide de refroidissement est en communication avec un sous-ensemble (dont les limites sont matérialisées par des traits forts à la figure 4) de l'ensemble de canaux de circulation 13a, 13b.

Ici, le sous-ensemble de l'ensemble de canaux de circulation 13a, 13b correspond à une partie des canaux de circulation 13a, 13b s'étendant au centre de la plaque froide 10, selon la direction longitudinale Y de la plaque froide 30.

Le connecteur de sortie 34 du fluide de refroidissement est alors en communication avec le même sous-ensemble de l'ensemble de canaux de circulation 13a, 13b afin de permettre l'évacuation du fluide de refroidissement.

On notera qu'en fonction du modèle de l'âme 13, de la disposition des canaux de circulation 13a, 13b et du type d'éléments de raccord étanche 31, 32 choisi, le fluide de refroidissement peut suivre différents cheminements au travers de la plaque froide, et plus précisément au travers de l'âme 13 de la structure sandwich 10.

De manière générale, la plaque froide 30 peut ne mettre en oeuvre qu'un unique couloir de circulation d'un fluide de refroidissement, formé par un sous-ensemble de l'ensemble de canaux de circulation 13a, 13b, tel qu'illustré par exemple à la figure 4.

Dans ce cas, un seul type de fluide de refroidissement est mis en oeuvre, et par exemple un liquide tel que de l'eau ou un gaz tel que de l'air.

Comme illustré à la figure 4, le flux de fluide de refroidissement peut être limité en largeur, et en particulier occuper une largeur partielle de la plaque froide 30.

Toutefois, le circuit de fluide de refroidissement pourrait être mis en oeuvre sensiblement dans toute la largeur selon la direction transversale X de la plaque froide 30.

On notera que la structure de l'âme 13 décrite précédemment et la réalisation des canaux 13a, 13b entre les ondulations ou parois inclinées 13' de l'âme 13 permet d'obtenir, sans élément additionnel, une fermeture étanche de la plaque froide 30 au niveau des bords longitudinaux 30a, 30b.

Ainsi, la réalisation des canaux 13a, 13b entre les ondulations ou parois inclinées 13' de l'âme 13 évite l'utilisation de parois de fermeture le long des bords longitudinaux 30a, 30b de la plaque froide 30.

La réalisation de la plaque froide 30 est ainsi simplifiée et permet en outre un gain de masse, particulièrement avantageux lorsque la plaque froide est destinée à être utilisée dans un aéronef.

De même, grâce à la formation d'un ensemble de canaux de circulation 13a, 13b dans l'âme 13 de la plaque froide, on évite l'ajout de tubulures pour transporter le fluide de refroidissement à l'intérieur de la plaque froide.

Une telle plaque froide présente par conséquent une masse limitée, parfaitement compatible pour les utilisations visées, et notamment dans le domaine aéronautique. Alternativement, et comme illustré à la figure 5, la plaque froide 30 peut être conçue pour mettre en oeuvre plusieurs couloirs de circulation d'un fluide de refroidissement, et par exemple deux couloirs de circulation de fluide de refroidissement (dont les limites sont matérialisées par des traits forts à la figure 5) formés chacun par un sous-ensemble distinct de l'ensemble de canaux de circulation 13a, 13b.

Dans un tel cas, le fluide de refroidissement utilisé peut être identique dans les deux sous-ensembles de l'ensemble de canaux de circulation 13a, 13b ou au contraire, la plaque froide peut mettre en oeuvre des fluides de refroidissement différents, choisis également parmi les liquides, tel que de l'eau, ou les gaz, tel que de l'air.

Pour la mise en oeuvre du mode de réalisation illustré à la figure 5, chaque élément de raccord étanche 31, 32 comporte plusieurs connecteurs d'entrée 35, 36 ou de sortie 37, 38.

Cette disposition permet ainsi de générer un circuit de fluide de refroidissement en deux parties distinctes de la plaque froide 30.

Le second mode de réalisation permet en outre d'utiliser des fluides de refroidissement différents et par exemple d'associer un fluide de refroidissement liquide tel que de l'eau à un fluide de refroidissement gazeux tel que de l'air.

On notera en référence aux figures 4 et 5 qu'un simple changement des éléments de raccord étanche 31, 32 permet à partir d'une même structure sandwich 10 de réaliser une plaque froide 30 avec différents types de couloir de circulation d'un fluide de refroidissement au travers de la plaque froide 30.

Les connecteurs d'entrée 33, 35, 36 et les connecteurs de sortie 34, 37, 38 décrits précédemment peuvent être de tout type, et par exemple être constitués chacun par des connecteurs rapides pour permettre le raccordement aisé et le montage/démontage simplifié de la plaque froide 30 au sein d'un circuit de circulation de fluide de refroidissement.

Ces connecteurs rapides sont des composants classiques et n'ont pas besoin d'être décrits plus précisément ici.

En particulier, ils permettent une connexion rapide et étanche à des tuyauteries 40, schématisées aux figures 4 et 5.

Le système de refroidissement de composants générateurs de chaleur, obtenu en plaçant des composants générateurs de chaleur 20 en contact avec l'une et/ou l'autre des deux plaques 11, 12 de la plaque froide 30, permet un refroidissement efficace des composants générateurs de chaleur 20, notamment grâce à la circulation d'un fluide de refroidissement dans l'âme 13 directement en contact avec les plaques 11, 12 de la plaque froide 30.

Par ailleurs, la structure sandwich 10 permet de conférer à la plaque froide 30 une bonne rigidité mécanique.

La plaque froide 30 peut ainsi être utilisée directement comme partie structurale d'un équipement avionique dans un aéronef.

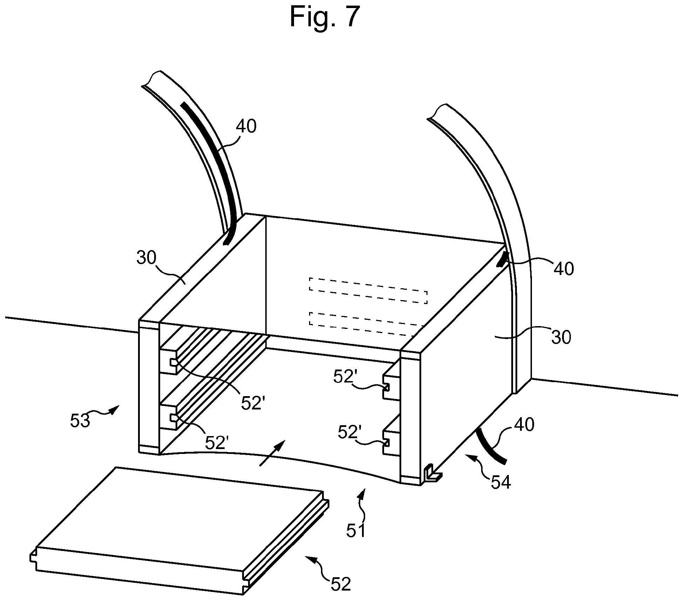

On a illustré ainsi à titre d'exemple non limitatif un exemple d'utilisation de plaque froide 30 à la figure 7.

Plus généralement, la plaque froide 30 peut être utilisée comme partie structurale d'un équipement LRU/LRM (acronymes des termes anglo-saxons *"Line Repleacable-Unit"* et *"Line Repleacable Module"*)*,* d'une structure électronique du type cabinet ou de type armoire électrique ou électronique.

Ici, comme illustré à la figure 7, un cabinet 51 destiné au montage d'un (ou plusieurs) équipement LRU/LRM 52 comporte deux plaques froides 30 permettant de réaliser une partie structurale 53, 54 du cabinet 51, et dans le mode de réalisation illustré à la figure 7, une paroi latérale gauche 53 et une paroi latérale droite 54 du cabinet 51.

L'équipement LRU/LRM 52, destiné à être monté sur des rails 52' dans le cabinet 51, est ainsi monté en contact directement avec les plaques froides 30 formant les parois latérales 53, 54 du cabinet 51.

On notera que les plaques froides 30, notamment du fait de leur résistance mécanique améliorée par la présence de l'âme 13 dans la structure sandwich 10, sont adaptées à être équipées de rails 52' pour le montage et le support des équipements LRU/LRM 52.

Dans ce type d'application, les plaques froides 30 sont connectées au circuit de circulation du fluide de refroidissement, et notamment connectées de manière étanche à des tuyauteries d'aéronef (*"A*/*C pipes"* en terminologie anglo-saxonne), référencées de manière générique par les tubulures 40 à la figure 7.

Bien entendu, de nombreuses modifications peuvent être apportées aux exemples de réalisation décrits précédemment.

Ainsi, la structure en zigzag de l'âme 13 dans le plan de la structure sandwich 10 n'est qu'un mode de réalisation pour former un ensemble de canaux de circulation dans la structure sandwich.

En particulier, les canaux pourraient s'étendre parallèlement à la direction longitudinale Y de la structure sandwich 10 et de la plaque froide 30.

## Revendications

1. Plaque froide pour le refroidissement de composants générateurs de chaleur (20), comprenant deux plaques (11, 12) s'étendant parallèlement l'une à l'autre et une âme (13) disposée entre lesdites deux plaques (11, 12) pour former une structure sandwich (10), ladite âme (13) comprenant un ensemble de canaux de circulation (13a, 13b) d'au moins un fluide de refroidissement d'un premier bord (10a) à un second bord opposé (10b) de ladite structure sandwich (10), **caractérisée en ce que** des premier et second éléments de raccord étanche (31, 32) sont disposés respectivement auxdits premier et second bords opposés (10a, 10b) de la structure sandwich (10), le premier élément de raccord étanche (31) comportant au moins un connecteur d'entrée (33 ; 35, 36) dudit au moins un fluide de refroidissement et le second élément de raccord étanche (32) comportant au moins un connecteur de sortie (34 ; 37, 38) dudit au moins un fluide de refroidissement, les premier et second éléments de raccord étanche (31, 32) obturant l'ensemble de canaux de circulation (13a, 13b) hormis au moins un sous-ensemble dudit ensemble de canaux de circulation (13a, 13b), ledit au moins un connecteur d'entrée (33 ; 35, 36) d'au moins un fluide de refroidissement étant en communication avec ledit sous-ensemble dudit ensemble de canaux de circulation (13a, 13b), et ledit au moins un connecteur de sortie (34 ; 37, 38) dudit au moins un fluide de refroidissement étant en communication avec ledit sous-ensemble dudit ensemble de canaux de circulation (13a, 13b).

2. Plaque froide conforme à la revendication 1, **caractérisée en ce que** ledit premier élément de raccord étanche (31), respectivement ledit second élément de raccord étanche (32), comporte plusieurs connecteurs d'entrée (35, 36), respectivement plusieurs connecteurs de sortie (37, 38), dudit au moins un fluide de refroidissement.

3. Plaque froide conforme à l'une des revendications 1 ou 2, **caractérisée en ce que** les premier et second éléments de raccord étanche (31, 32) sont insérés et fixés entre lesdites deux plaques (11, 12) se prolongeant au-delà de l'âme (13).

4. Plaque froide conforme à l'une des revendications 1 à 3, **caractérisée en ce que** ledit ensemble de canaux de circulation (13a, 13b) comprend des canaux (13a, 13b) fermés par au moins l'une desdites deux plaques (11, 12) et débouchant respectivement audit premier bord (10a) et audit second bord opposé (10b) de ladite structure sandwich.

5. Plaque froide conforme à la revendication 4, **caractérisée en ce que** lesdits canaux (13a, 13b) comprennent chacun deux parois (13') respectivement adjacentes à au moins l'une desdites deux plaques (11, 12).

6. Plaque froide conforme à la revendication 5, **caractérisée en ce que** lesdites deux parois (13') sont inclinées l'une par rapport à l'autre et adjacentes l'une à l'autre pour former un fond de canal (13c).

7. Plaque froide conforme à l'une des revendications 4 à 6, **caractérisée en ce que** l'âme (13) a une forme ondulée, le sommet (13c) des ondulations étant en contact avec au moins l'une desdites deux plaques (11, 12).

8. Plaque froide conforme à l'une des revendications 4 à 7, **caractérisée en ce que** la direction de circulation dudit au moins un fluide de refroidissement dans ledit ensemble de canaux de circulation (13a, 13b) correspond à une direction longitudinale (Y) de ladite structure sandwich (10), l'âme (13) réalisant une fermeture étanche de ladite plaque froide (30) sur des bords longitudinaux (30a, 30b) de la plaque froide (30).

9. Plaque froide conforme à l'une des revendications 1 à 8, **caractérisée en ce que** l'ensemble de canaux de circulation (13a, 13b) comprend des canaux (13a, 13b) parallèles les uns aux autres.

10. Plaque froide conforme à la revendication 9, **caractérisée en ce que** les canaux de circulation (13a, 13b) sont disposés en zigzag dudit premier bord (10a) audit second bord opposé (10b) de la structure sandwich (10).

11. Système de refroidissement de composants générateurs de chaleur, **caractérisé en ce qu'**il comprend une plaque froide (30) conforme à l'une des revendications 1 à 10, des composants générateurs de chaleur (20) étant disposés en contact avec au moins l'une desdites deux plaques (11, 12).

12. Utilisation d'une plaque froide conforme à l'une des revendications 1 à 10 comme partie structurale (53, 54) d'un équipement avionique (51) dans un aéronef.

## Patentansprüche

1. Kälteplatte für die Kühlung von Wärmeerzeugungskomponenten (20), die zwei Platten (11, 12), die sich parallel zueinander erstrecken, und einen Kern (13), der zwischen diesen beiden Platten (11, 12) angeordnet ist, umfasst, um eine Sandwich-Struktur (10) zu bilden, wobei der Kern (13) eine Anordnung von Zirkulationskanälen (13a, 13b) für wenigstens ein Kühlungsfluid von einem ersten Rand (10a) zu einem gegenüberliegenden zweiten Rand (10b) der Sandwich-Struktur (10) aufweist, **dadurch gekennzeichnet, dass** ein erstes und ein zweites dichtes Verbindungselement (31, 32) an dem ersten bzw. dem zweiten Rand (10a, 10b) der Sandwich-Struktur (10), die einander gegenüberliegen, angeordnet sind, wobei das erste dichte Verbindungselement (31) wenigstens einen Eingangsverbinder (33; 35, 36) für das wenigstens eine Kühlungsfluid umfasst und das zweite dichte Verbindungselement (32) wenigstens einen Ausgangsverbinder (34; 37, 38) für das wenigstens eine Kühlungsfluid umfasst, wobei das erste und das zweite dichte Verbindungselement (31, 32) die Anordnung von Zirkulationskanälen (13a, 13b) bis auf wenigstens eine Unteranordnung der Anordnung von Zirkulationskanälen (13a, 13b) verschließt, wobei der wenigstens eine Eingangsverbinder (33; 35, 36) für wenigstens ein Kühlungsfluid mit der Unteranordnung der Anordnung von Zirkulationskanälen (13a, 13b) kommuniziert und der wenigstens eine Ausgangsverbinder (34; 37, 38) für wenigstens ein Kühlungsfluid mit der Unter- anordnung der Anordnung von Zirkulationskanälen (13a, 13b) kommuniziert.

2. Kälteplatte nach Anspruch 1, **dadurch gekennzeichnet, dass** das erste dichte Verbindungselement (31) bzw. das zweite dichte Verbindungselement (32) mehrere Eingangsverbände (35, 36) bzw. mehrere Ausgangsverbinder (37, 38) für das wenigstens eine Kühlungsfluid umfassen.

3. Kälteplatte nach einem der Ansprüche 1 oder 2, **dadurch gekennzeichnet, dass** das erste und das zweite dichte Verbindungselement (31, 32) zwischen den zwei Platten (11, 12) eingesetzt und befestigt sind und über den Kern (13) hinaus verlängert sind.

4. Kälteplatte nach einem der Ansprüche 1 bis 3, **dadurch gekennzeichnet, dass** die Anordnung von Zirkulationskanälen (13a, 13b) Kanäle (13a, 13b) umfasst, die durch wenigstens eine der beiden Platten (11, 12) verschlossen sind und in den ersten (10a) bzw. den gegenüberliegenden zweiten Seitenrand (10b) der Sandwich-Struktur münden.

5. Kälteplatte nach Anspruch 4, **dadurch gekennzeichnet, dass** die Kanäle (13a, 13b) jeweils zwei Wände (13') aufweisen, die jeweils zu wenigstens einer der beiden Platten (11, 12 benachbart sind.

6. Kälteplatte nach Anspruch 5, **dadurch gekennzeichnet, dass** die beiden Wände (13') zueinander geneigt sind und zueinander benachbart sind, um einen Kanalboden (13c) zu bilden.

7. Kälteplatte nach einem der Ansprüche 4 bis 6, **dadurch gekennzeichnet, dass** der Kern (13) eine gewellte Form hat, wobei die Spitze (13c) der Welligkeiten mit wenigstens einer der beiden Platten (11, 12) Kontakt ist.

8. Kälteplatte nach einem der Ansprüche 4 bis 7, **dadurch gekennzeichnet, dass** die Zirkulationsrichtung des wenigsten einen Kühlungsfluids in der Anordnung von Zirkulationskanälen (13a, 13b) einer Längsrichtung (Y) der Sandwich-Struktur (10 entspricht, wobei der Kern (13) ein dichtes Verschließen der Kälteplatte (30) auf longitudinalen Rändern (30a, 30b) der Kälteplatte (30) verwirklicht.

9. Kälteplatte nach einem der Ansprüche 1 bis 8, **dadurch gekennzeichnet, dass** die Anordnung von Zirkulationskanälen (13a, 13b) zueinander parallele Kanäle (13a, 13b) umfasst.

10. Kälteplatten Anspruch 9, **dadurch gekennzeichnet, dass** die Zirkulationskanäle (13a, 13b) von dem ersten Rand (10a) zu dem gegenüberliegenden zweiten Rand (10b) der Sandwich-Struktur (10) zickzackförmig angeordnet sind.

11. System zum Kühlen von Wärmeerzeugungskomponenten, **dadurch gekennzeichnet, dass** es eine Kälteplatte (30) nach einem der Ansprüche 1 bis 10 umfasst, wobei Wärmeerzeugungskomponenten (20) in Kontakt mit wenigstens einer der beiden Platten (11, 12) angeordnet sind.

12. Verwendung einer Kälteplatte nach einem der Ansprüche 1 bis 10 als ein strukturgebendes Teil (53, 54) einer Avionikausrüstung (51) in einem Flugzeug.

## Claims

1. Cold plate for cooling heat-generating components (20), comprising two plates (11, 12) extending parallel to one another and a core (13) disposed between said two plates (11, 12) to form a sandwich structure (10), said core (13) comprising a set of passages (13a, 13b) for passing at least one cooling fluid from a first edge (10a) to an opposite second edge (10b) of said sandwich structure (10), **characterised in that** first and second fluid-tight joining members (31, 32) are disposed respectively on said first and second opposite edges (10a, 10b of the sandwich structure (10), the first fluid-tight joining member (31) comprising at least one inlet connector (33; 35, 36) for said at least one cooling fluid and the second fluid-tight joining member (32) comprising at least one outlet connector (34; 37, 38) for said at least one cooling fluid, the first and second fluid-tight joining members (31, 32) blocking all the passages (13a, 13b) except at least one subset of said set of passages (13a, 13b), said at least one inlet connector (33; 35, 36) for at least one cooling fluid being connected with said subset of said set of passages (13a, 13b), and said at least one outlet connector (34; 37, 38) for said at least one cooling fluid being connected with said subset of said set of passages (13a, 13b).

2. Cold plate according to claim 1, **characterised in that** said first fluid-tight joining member (31), respectively said second fluid-tight joining member (32), comprises a number of inlet connectors (35, 36), respectively a number of outlet connectors (37, 38), for said at least one cooling fluid.

3. Cold plate according to either of claims 1 and 2, **characterised in that** the first and second fluid-tight joining members (31, 32) are inserted and fixed between said two plates (11, 12) extending beyond the core (13).

4. Cold plate according to one of claims 1 to 3, **characterised in that** said set of passages (13a, 13b) comprises passages (13a, 13b) closed by at least one of said two plates (11, 12) and emerging respectively on said first edge (10a) and on said opposite second edge (10b) of said sandwich structure.

5. Cold plate according to claim 4, **characterised in that** said passages (13a, 13b) each comprise two walls (13') respectively adjacent to at least one of said two plates (11, 12).

6. Cold plate according to claim 5, **characterised in that** said two walls (13') are inclined relative to one another and adjacent to one another to form a passage bottom (13c).

7. Cold plate according to one of claims 4 to 6, **characterised in that** the core (13) has a wavy form, the top (13c) of the waves being in contact with at least one of said two plates (11, 12).

8. Cold plate according to one of claims 4 to 7, **characterised in that** the direction of passage of said at least one cooling fluid in said set of passages (13a, 13b) corresponds to a longitudinal direction (Y) of said sandwich structure (10), the core (13) producing a fluid-tight closure of said cold plate (30) on longitudinal edges (30a, 30b) of the cold plate (30).

9. Cold plate according to one of claims 1 to 8, **characterised in that** the set of passages (13a, 13b) comprises passages (13a, 13b) parallel to one another.

10. Cold plate according to claim 9, **characterised in that** the passages (13a, 13b) are disposed zigzag fashion from said first edge (10a) to said opposite second edge (10b) of the sandwich structure (10).

11. System for cooling heat-generating components, **characterised in that** it comprises a cold plate (30) according to one of claims 1 to 10, heat-generating components (20) being disposed in contact with at least one of said two plates (11, 12).

12. Use of a cold plate according to one of claims 1 to 10 as a structural part (53, 54) of an avionics equipment item (51) in an aircraft.
